# EUROPEAN PATENT APPLICATION

(11) **EP 4 521 870 A1**
(43) Date of publication of application: **12.03.2025**
(21) Application number: 23829355.9
(22) Date of filing: 13.01.2023
(51) Int. Cl.: H05K 7/20

(54) **HEAT SINK AND COMMUNICATION DEVICE**

(30) Priority: 27.06.2022 CN 202210736640
(71) Applicant: ZTE Corporation, Shenzhen, Guangdong 518057 (CN)
(72) Inventor: DUAN, Kaiwen, Shenzhen, Guangdong 518057 (CN); NIE, Zhidong, Shenzhen, Guangdong 518057 (CN); LIU, Xin, Shenzhen, Guangdong 518057 (CN); WANG, Yan, Shenzhen, Guangdong 518057 (CN); CHEN, Xiaoxue, Shenzhen, Guangdong 518057 (CN); LIU, Fan, Shenzhen, Guangdong 518057 (CN); LI, Shuai, Shenzhen, Guangdong 518057 (CN)
(74) Representative: WBH Wachenhausen Patentanwälte PartG mbB
(86) International application number: PCT/CN2023/072113
(87) International publication number: WO 2024/001162

(57) **Abstract**

The present application discloses a heat sink (100) and a communication device. The heat sink (100) comprises a heat dissipation substrate (110) and a plurality of heat dissipation fins (120). The heat dissipation substrate (110) is used for absorbing heat of a heat source. A substrate cavity and a blocking structure (210) are formed within the heat dissipation substrate (110). The blocking structure (210) is used for dividing the substrate cavity into a plurality of substrate cavity bodies (220). Refrigerant working media in two adjacent substrate cavity bodies (220) do not circulate. The plurality of heat dissipation fins (120) are connected to the heat dissipation substrate (110).

## Description

### CROSS-REFERENCE TO RELATED APPLICATION

This application is filed on the basis of Chinese patent application No. 202210736640.3 filed June 27, 2022, and claims priority to the Chinese patent application, the entire contents of which are incorporated herein by reference.

### TECHNICAL FIELD

The present disclosure relates to the technical field of communication, and more particularly, to a heat sink and a communication device.

### BACKGROUND

With the rapid advancement of power electronics technology, electronic devices are evolving toward larger capacity, higher power, greater integration, and reduced weight. This has resulted in increased heat consumption density and heightened demands for environmental adaptability. Ensuring reliable heat dissipation for these devices has gradually become a challenge for the industry. Existing heat sinks primarily use two-phase fins with high thermal conductivity and high heat transfer capability to replace metal fins of conventional heat sinks. While these two-phase fins significantly enhance heat dissipation efficiency, they are unable to address the issue of localized overheating at high heat fluxes when the substrate's local heat generation is excessive, and they lack sufficient reliability.

### SUMMARY

The following is a summary of the subject matter set forth in this description. This summary is not intended to limit the scope of protection of the claims.

Embodiments of the present disclosure provide a heat sink and a communication device.

In accordance with a first aspect of the present disclosure, an embodiment provides a heat sink, including: a heat dissipation substrate, configured for absorbing heat from a heat source, where a substrate cavity and a partition structure are arranged in the heat dissipation substrate, the partition structure is configured for dividing the substrate cavity into a plurality of substrate cavity bodies, and refrigerant working medium in every two adjacent substrate cavity bodies are not in circulation with each other; and a plurality of heat dissipation fins, connected to the heat dissipation substrate.

In accordance with a second aspect of the present disclosure, an embodiment provides a communication device, including the heat sink in accordance with the first aspect.

Additional features and advantages of the present disclosure will be set forth in the description which follows, and in part will be apparent from the description, or may be learned by the practice of the present disclosure. The objects and other advantages of the present disclosure can be realized and obtained by the structures particularly pointed out in the description, claims and drawings.

### BRIEF DESCRIPTION OF DRAWINGS

The drawings are provided for a further understanding of the technical schemes of the present disclosure, and constitute a part of the description. The drawings and the embodiments of the present disclosure are used to illustrate the technical schemes of the present disclosure, but are not intended to limit the technical schemes of the present disclosure.
FIG. 1 is a schematic diagram of a heat sink according to an embodiment of the present disclosure;
FIG. 2 is a cross-sectional view of a heat sink according to an embodiment of the present disclosure;
FIG. 3 is a horizontal cross-sectional view of a heat dissipation substrate of a heat sink according to an embodiment of the present disclosure;
FIG. 4 is a schematic diagram of a heat sink where a substrate cavity and a two-phase conduit of a heat dissipation fin are independent two-phase circulation structures according to an embodiment of the present disclosure;
FIG. 5 is a schematic diagram of a heat sink where a two-phase conduit of a heat dissipation fin and a substrate cavity are in communication with each other to form a connected two-phase circulation structure according to an embodiment of the present disclosure;
FIG. 6 is a schematic diagram of a heat sink where a partition structure is arranged parallel to a length direction of the heat dissipation fin according to an embodiment of the present disclosure;
FIG. 7 is a schematic diagram of a heat sink where a partition structure is arranged perpendicular to a length direction of the heat dissipation fin according to an embodiment of the present disclosure;
FIG. 8 is a schematic diagram of a heat sink where a partition structure is arranged perpendicular to a length direction of the heat dissipation fin according to an embodiment of the present disclosure;
FIG. 9 is a schematic diagram of a heat sink where a partition structure is arranged inclined to a length direction of the heat dissipation fin according to an embodiment of the present disclosure;
FIG. 10 is a schematic diagram of supporting columns of a heat dissipation substrate of a heat sink according to an embodiment of the present disclosure;
FIG. 11 is a schematic diagram of supporting columns of a heat dissipation substrate of a heat sink according to another embodiment of the present disclosure;
FIG. 12 is a schematic diagram of a heat sink where bent portions on tops of heat dissipation fins form a cover structure according to an embodiment of the present disclosure; and
FIG. 13 is a schematic diagram of a peripheral flange of a heat dissipation substrate of a heat sink according to an embodiment of the present disclosure.

### DETAILED DESCRIPTION

To make the objects, technical schemes, and advantages of the present disclosure clear, the present disclosure is described in further detail in conjunction with accompanying drawings and examples. It should be understood that the specific embodiments described herein are merely used for illustrating the present disclosure, and are not intended to limit the present disclosure.

It should be noted that the terms such as "plurality of" or "multiple" in the description, claims, and accompanying drawings mean two or more.

The present disclosure provides a heat sink and a communication device. The heat sink includes a heat dissipation substrate and a plurality of heat dissipation fins. The heat dissipation substrate is configured for absorbing heat from a heat source. A substrate cavity and a partition structure are arranged in the heat dissipation substrate. The partition structure is configured for dividing the substrate cavity into a plurality of substrate cavity bodies. Refrigerant working medium in every two adjacent substrate cavity bodies are not in circulation with each other. The plurality of heat dissipation fins are connected to the heat dissipation substrate. In the technical schemes of the embodiments of the present disclosure, compared with the design of an integrated cavity, the design of the plurality of substrate cavity bodies in the heat dissipation substrate makes it technologically easier to meet the sealing performance of each small substrate cavity body, and dry burning, if any, occurs only in part of the substrate cavity bodies, so as not to affect the heat dissipation ability of the entire heat sink. Therefore, the reliability and redundancy of the heat sink designed with a plurality of substrate cavity bodies can be improved. In addition, the structures of different substrate cavity bodies can be configured according to different heat source requirements to match the heat source, so as to improve the local heat dissipation capability of the heat sink.

The embodiments of the present disclosure will be further described in detail below in conjunction with the accompanying drawings.

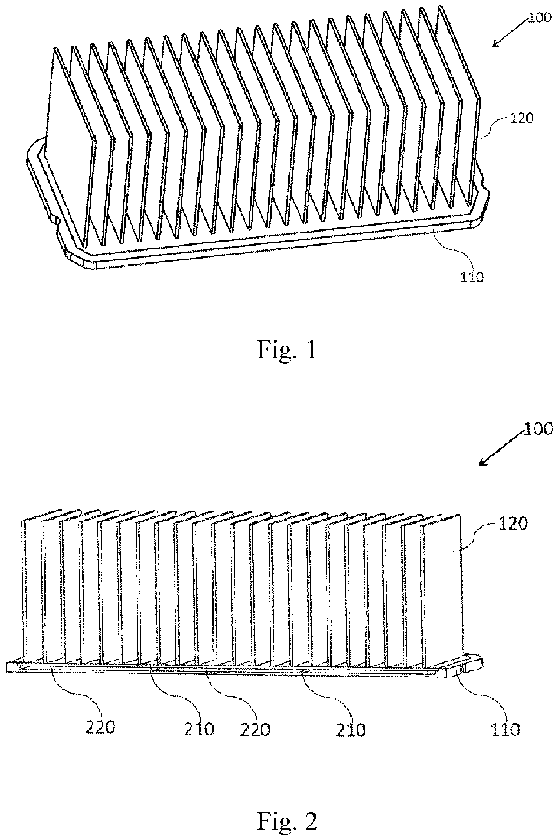

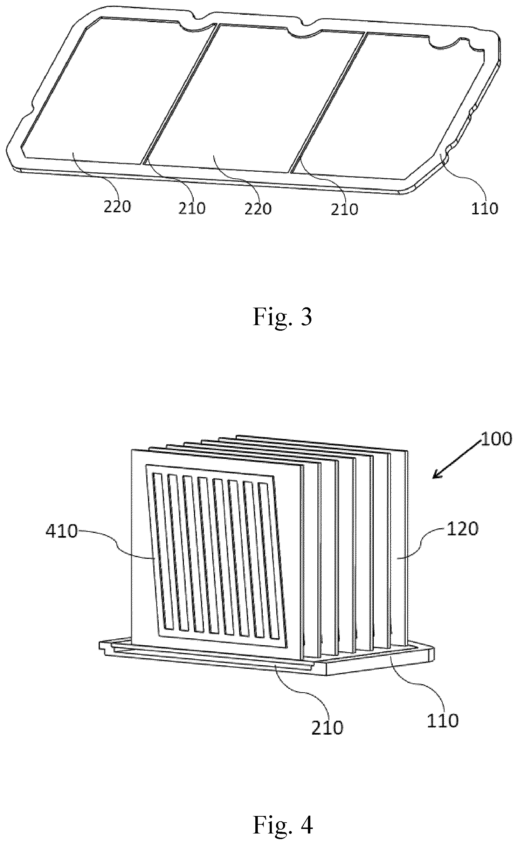

As shown in FIG. 1, FIG. 2, and FIG. 3, FIG. 1 is a schematic diagram of a heat sink according to an embodiment of the present disclosure, FIG. 2 is a cross-sectional view of a heat sink according to an embodiment of the present disclosure, and FIG. 3 is a horizontal cross-sectional view of a heat dissipation substrate of a heat sink according to an embodiment of the present disclosure. The heat sink 100 includes a heat dissipation substrate 110 and a plurality of heat dissipation fins 120. The heat dissipation substrate 110 is configured for absorbing heat from a heat source. A substrate cavity and a partition structure 210 are arranged in the heat dissipation substrate 110. The partition structure 210 is configured for dividing the substrate cavity into a plurality of substrate cavity bodies 220. Refrigerant working medium in every two adjacent substrate cavity bodies 220 are not in circulation with each other. The plurality of heat dissipation fins 120 are connected to the heat dissipation substrate 110. In the technical scheme of this embodiment, the design of the plurality of substrate cavity bodies 220 in the heat dissipation substrate 110 improves the reliability and redundancy of the heat sink 100. In addition, the structures of the substrate cavity bodies 220 can be configured according to different heat source requirements to match the heat source, so as to improve the local heat dissipation capability of the heat sink 100.

It should be noted that the heat dissipation fins 120 may be ordinary metal fins, or may be two-phase heat dissipation fins provided with a two-phase conduit 410 and filled with a refrigerant therein, which is not particularly limited in this embodiment.

It should be noted that the heat dissipation fins 120 may be connected to the heat dissipation substrate 110 by engagement, adhesion, riveting, or welding, which is not particularly limited in this embodiment.

It should be noted that the partition structure 210 may be a partition plate or a partition strip, and may form an integrated or split structure with the heat dissipation substrate, which is not particularly limited in this embodiment.

As shown in FIG. 1, the heat dissipation fins 120 may be ordinary metal fins. In this case, only the substrate cavity needs to be filled with a refrigerant working medium, and heat spreading is realized within a planar range of the substrate through two-phase heat transfer.

It should be noted that all or part of the substrate cavity bodies 220 are filled with the refrigerant working medium, which is not particularly limited in this embodiment.

The heat dissipation fins 120 are two-phase heat dissipation fins provided with a two-phase conduit 410 and filled with a refrigerant therein. In this case, two-phase heat transfer is provided both in a flat plate range (horizontal) of the heat dissipation substrate 110 and in a heat dissipation plane range (vertical) of the heat dissipation fins 120, such that the heat source on the back of the substrate can spread heat in a three-dimensional space. As shown in FIG. 4, when the heat dissipation fins 120 are two-phase heat dissipation fins, the two-phase conduit 410 of the heat dissipation fin 120 may be an independent conduit, which is independent of the substrate cavity. In this case, the substrate cavity and the two-phase conduit 410 of the heat dissipation fin 120 are independent two-phase circulation structures. The design of the substrate cavity bodies of the substrate cavity is independent of the design of the two-phase conduits 410 of the heat dissipation fins, and the substrate cavity can be designed as required.

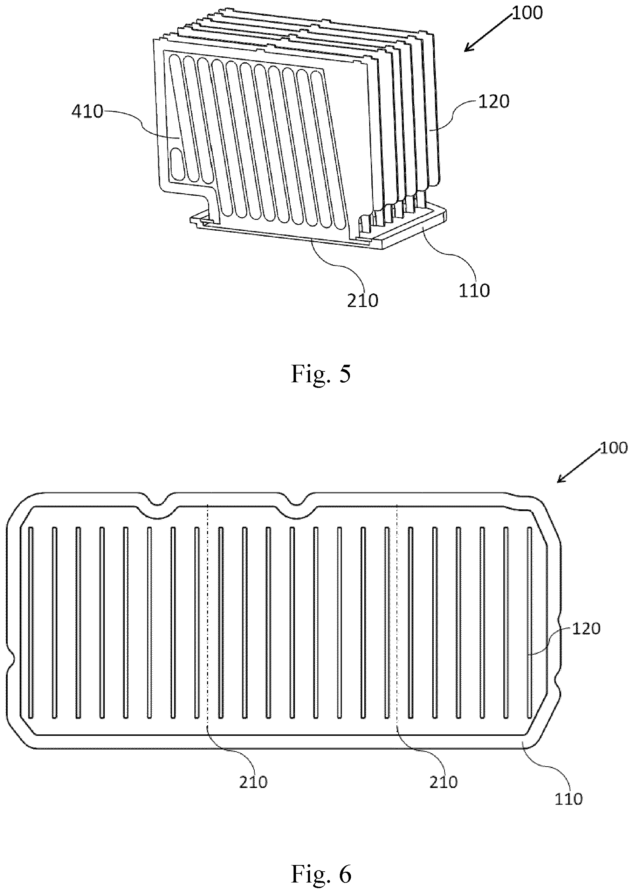

As shown in FIG. 5, the two-phase conduit 410 of the heat dissipation fin 120 is an open conduit in communication with the substrate cavity of the heat dissipation substrate. In this case, the two-phase conduit 410 of the heat dissipation fin 120 is in communication with the substrate cavity of the heat dissipation substrate 110 to form a connected two-phase circulation structure. As the heat sink 100 of the two-phase structure adopts the design of the plurality of substrate cavity bodies 220 in the heat dissipation substrate, it is technologically easier to meet the sealing performance of each small substrate cavity body 220 compared with the use of the design of an integrated cavity, and dry burning, if any, occurs only in part of the substrate cavity bodies 220, so as not to affect the heat dissipation ability of the entire heat sink. Therefore, the reliability and redundancy of the heat sink designed with a plurality of substrate cavity bodies 220 can be improved. In addition, the substrate cavity can be designed according to the position characteristics of heat source distribution, to improve the efficiency of two-phase heat dissipation. For example, local high heat flux regions at multiple locations are respectively designed as multiple independent two-phase circulation regions to realize the independent two-phase heat transfer and dissipation properties of the high heat flux regions, thereby effectively improving the overall heat dissipation efficiency. It should be noted that the mode of communication between the substrate cavity body 220 and the two-phase conduit 410 may be that one substrate cavity body 220 is independently in communication with one two-phase conduit 410, one substrate cavity body 220 is independently in communication with a plurality of two-phase conduits 410, or two substrate cavity bodies 220 are in communication with one two-phase conduit 410, which is not particularly limited in this embodiment.

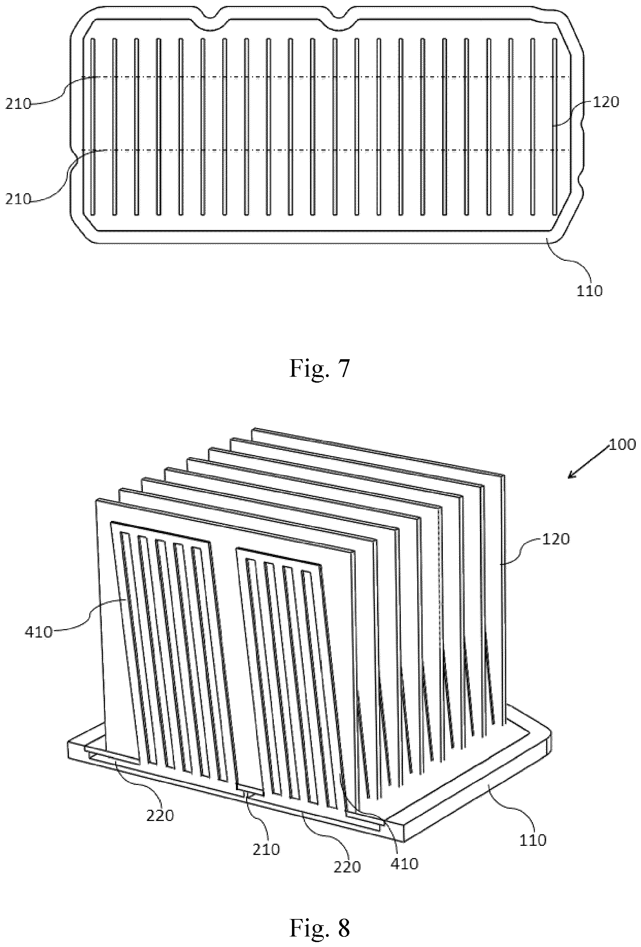

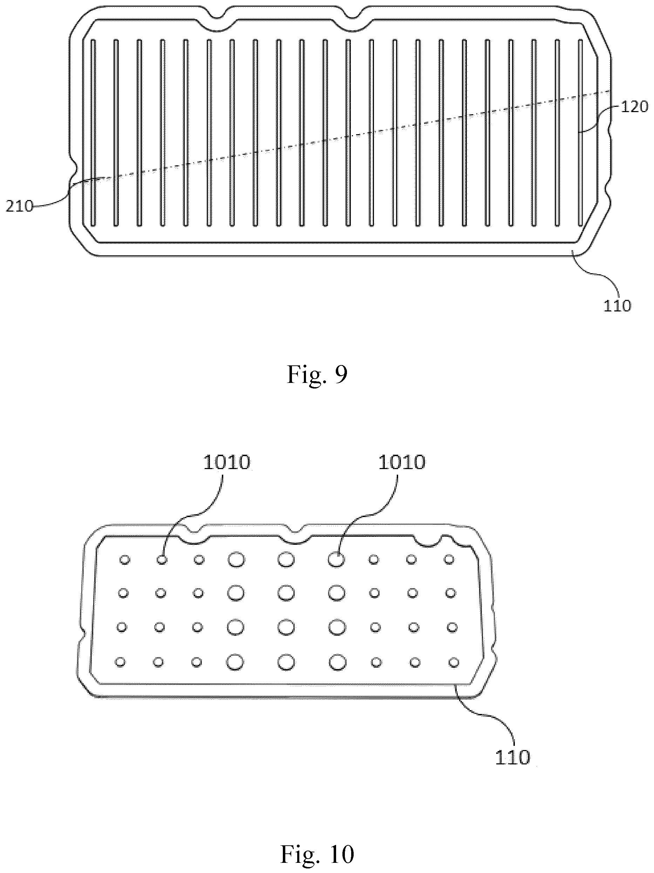

When the two-phase conduits 410 of the heat dissipation fins 120 are in communication with the substrate cavity of the heat dissipation substrate 110, each of the substrate cavity bodies 220 forms an independent loop with the corresponding two-phase conduit 410. As shown in FIG. 6, when the partition structure 210 is arranged parallel to a length direction of the heat dissipation fin 120, each substrate cavity body 220 and the two-phase conduits 410 of all the heat dissipation fins 120 in the region corresponding to the substrate cavity body 220 together constitute a plurality of independent two-phase circulation regions. Alternatively, as shown in FIG. 7 and FIG. 8, when the partition structure 210 is arranged perpendicular to the length direction of the heat dissipation fin 120, a plurality of independent two-phase conduits 410 need to be arranged on the heat dissipation fins 120 according to the substrate cavity bodies 220 on the heat dissipation substrate 110, such that the two-phase conduits 410 of the heat dissipation fins 120 and the substrate cavity together form two-phase circulation regions, which are not in communication with each other, corresponding to the plurality of substrate cavity bodies 220. Alternatively, as shown in FIG. 9, when the partition structure 210 is arranged inclined to the length direction of the heat dissipation fin 120, a plurality of independent two-phase conduits 410 need to be arranged on the heat dissipation fins 120 according to the substrate cavity bodies 220 on the heat dissipation substrate 110, such that the two-phase conduits 410 of the heat dissipation fins 120 and the substrate cavity together form two-phase circulation regions, which are not in communication with each other, corresponding to the plurality of substrate cavity bodies 220. It should be noted that the number of two-phase conduits 410 in the two-phase heat dissipation fin may be equal to the number of the substrate cavity bodies 220 in communication with the two-phase heat dissipation fin, or may be greater than the number of the substrate cavity bodies 220 in communication with the two-phase heat dissipation fin, i.e., one heat dissipation fin 120 is provided with a plurality of two-phase conduits 410 in one substrate cavity body 220. It can be understood that a two-phase conduit 410 in this embodiment means an uninterrupted conduit, and the two-phase conduit 410 may be in various shapes, which is not particularly limited in this embodiment.

In an embodiment, in the structure of the heat sink 100 according to the above embodiments, a groove is provided on an inner cavity surface of the heat dissipation substrate 110, especially on an inner cavity surface of a heat source coverage region, to form a local liquid storage structure. A condensate flowing back under gravity will be stopped by the groove and thus retained in the groove. The condensate in the groove is heated by the heat source on the back of the substrate to quickly evaporate and take away the heat, such that the problem of dry burning in a local heat source region can be effectively alleviated.

When the heat dissipation substrate 110 is applied in a vertical state, an upper part of the substrate is prone to hot vapor accumulation due to gravity, resulting in dry burning. In this case, a groove may be provided in the region of an inner cavity surface of the substrate cavity body 220 in the heat dissipation substrate 110 corresponding to middle and upper heat sources. When the condensate at a lower part is carried by rising vapor to surge up, or the condensate in the two-phase heat dissipation fin flows back to this position for replenishing, the groove can provide a liquid storage effect to retain the liquid flowing through the groove surface, such that the liquid can stay for a longer period of time and soak the inner cavity surface of the heat dissipation substrate 110 in this region, thereby alleviating the problem of dry burning on the upper part of the substrate during anti-gravity applications.

It should be noted that capillary structures such as micro-channels and sintered capillaries may be provided inside the groove having the liquid storage function, to improve heat dissipation of the middle and upper heat sources of the heat dissipation substrate 110 in combination with the characteristics of the groove.

In an embodiment, in the structure of the heat sink 100 according to the above embodiments, the inner cavity surface of the heat dissipation substrate 110 is a rough surface. The rough surface is prepared by sandblasting and/or by cold spraying of metal particles, to form surface microstructure features that enhance boiling heat transfer. For the surface microstructure features, a region centered on the center of the heat source and having an area that is 1.5 times the area of the heat source is used as a surface treatment region, so as to achieve an objective of locally enhancing heat dissipation of a chip.

On the one hand, sandblasting is a subtractive manufacturing process, in which the inner cavity surface is impacted and worn by high-speed sand particles, forming countless small pits in the corresponding area, i.e., a group of tiny pits. During the heating process, the pit is more likely to form a vaporization core and generate bubbles, which significantly increases the evaporation rate of the local refrigerant working medium.

On the other hand, cold spraying of metal particles is an additive manufacturing process, in which small-sized metal particles (copper, aluminum, etc.) are impinged at high speed to attach to the inner cavity surface to form a group of tiny capillary particles. Pits of different sizes are formed between the particles, which can also increase vaporization cores. After the heat dissipation substrate 110 absorbs heat, the heat is transferred to the metal particles through the substrate. **In** this case, the liquid refrigerant working medium in the pits is heated by the surfaces of the powder particles, to gradually form small bubbles in the pits, thereby significantly increasing the local evaporation rate. It should be noted that surface microstructure features that enhance boiling heat transfer may also be provided inside the pits having the liquid storage function.

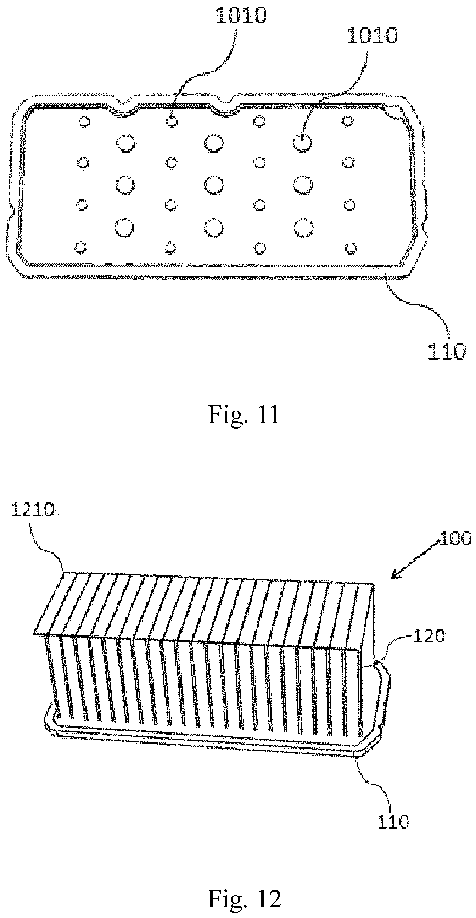

In an embodiment, in the structure of the heat sink 100 according to the above embodiments, it is necessary to improve the structural strength of the heat sink 100 in order to further improve the reliability of the heat sink 100. In practice, the refrigerant in the substrate cavity bodies 220 of the heat dissipation substrate 110 will be heated to evaporate, resulting in a sudden increase in the pressure of the substrate cavity body 220, such that the heat dissipation substrate 110 is very likely to swell in its middle part. The swelling of the middle part of the heat dissipation substrate 110 will cause a connection region between the heat dissipation substrate 110 and the heat dissipation fin 120 to warp, leading to multiple deformations, damage, and failure. To solve the above problems, a plurality of supporting columns 1010 may be arranged in the substrate cavity to increase the structural strength of the heat sink 100. Supporting columns 1010 of different diameters may be used in combination to increase the structural strength as required. For example, as shown in FIG. 10, large-diameter supporting columns 1010 are arranged in the middle, and small-diameter supporting columns 1010 are arranged on two sides. Alternatively, as shown in FIG. 11, small-diameter supporting columns 1010 are adopted in a large area, large-diameter supporting columns 1010 are adopted in a small area, and the large-diameter supporting columns and small-diameter supporting columns 1010 are arranged in a staggered manner. With the above strengthening method, the large-diameter supporting columns 1010 are used to increase the structural strength, and the small-diameter supporting columns 1010 are used to reduce the coverage area of physical parts and increase the coverage area of the cavity, thereby increasing the structural strength and enhancing heat dissipation.

It should be noted that the diameters of the plurality of supporting columns 1010 may be the same or different, which may be set according to the specific structure of the heat sink 100 and will not be particularly limited in this embodiment.

In an embodiment, to further improve the heat dissipation performance of the heat sink 100, as shown in FIG. 12, a top of the heat dissipation fin 120 may be bent to form a bent portion 1210, and the bent portions 1210 of a plurality of neighboring heat dissipation fins 120 are connected to each other to form a cover structure. In an embodiment, the coverage range of the two-phase conduit 410 of the heat dissipation fin 120 is extended to the bent portion 1210, such that the cover structure participates in two-phase heat dissipation. In this way, the heat diffusion range of two-phase heat transfer can be further expanded, and the heat diffusion region is closer to an external cold source, thereby further improving the overall two-phase heat dissipation efficiency of the heat sink 100.

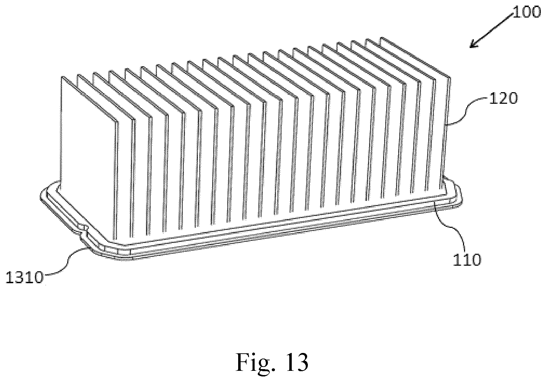

In an embodiment, when the heat sink 100 is connected to an external housing by welding (laser welding, friction stir welding, etc.), walls on two sides of a welding seam usually need to have the same thickness to facilitate the pressing and fixing by the welding fixture. Otherwise, because the material near the welding seam will melt into a liquid state during welding, the liquid material can flow freely to form a recess on a non-level surface, affecting the appearance of the weld and the quality of the welding. Generally speaking, when the thickness of the heat dissipation substrate 110 exceeds a thickness required for a welding depth, a peripheral flange 1310 may be provided. The thickness of the peripheral flange 1310 is consistent with the welding depth, and the width of the peripheral flange 1310 is consistent with an influence range of friction stir welding. As shown in FIG. 13, the design of the peripheral flange 1310 with a smaller thickness can reasonably reduce the structural thickness of the heat sink 100 and the external housing around the welding seam, thereby facilitating the overall lightweight design of the heat sink.

**In** addition, an embodiment of the present disclosure provides a communication device. The communication device includes the heat sink of the above embodiments. The communication device can realize the embodiments of the heat sink. The technical means used, the technical problem solved, and the effects achieved by the communication device are the same as those of the heat sink in the above embodiment, so the details will not be repeated herein, and reference may be made to the embodiments of the heat sink.

Embodiments of the present disclosure provide a heat sink and a communication device. The heat sink includes a heat dissipation substrate and a plurality of heat dissipation fins. The heat dissipation substrate is configured for absorbing heat from a heat source. A substrate cavity and a partition structure are arranged in the heat dissipation substrate. The partition structure is configured for dividing the substrate cavity into a plurality of substrate cavity bodies. Refrigerant working medium in every two adjacent substrate cavity bodies are not in circulation with each other. The plurality of heat dissipation fins are connected to the heat dissipation substrate. At present, most heat sinks available in the market adopt an integrated cavity design. As such, heat sinks have a large cavity volume. Therefore, it is difficult to ensure the sealing performance during manufacturing, and the finished products have the problems of low sealing performance and low reliability and require frequent maintenance. **In** the technical scheme of this embodiment, compared with the design of an integrated cavity, the design of the plurality of substrate cavity bodies in the heat dissipation substrate makes it technologically easier to meet the sealing performance of each small substrate cavity body, and dry burning, if any, occurs only in part of the substrate cavity bodies, so as not to affect the heat dissipation ability of the entire heat sink. Therefore, the reliability and redundancy of the heat sink designed with a plurality of substrate cavity bodies can be improved. **In** addition, the structures of different substrate cavity bodies can be configured according to different heat source requirements to match the heat source, so as to improve the local heat dissipation capability of the heat sink.

Although some embodiments of the present disclosure have been described above, the present disclosure is not limited to the implementations described above. Those having ordinary skills in the art can make various equivalent modifications or replacements without departing from the essence of the present disclosure. Such equivalent modifications or replacements fall within the scope defined by the claims of the present disclosure.

## Claims

1. A heat sink, comprising:
a heat dissipation substrate, configured for absorbing heat from a heat source, wherein a substrate cavity and a partition structure are arranged in the heat dissipation substrate, the partition structure is configured for dividing the substrate cavity into a plurality of substrate cavity bodies, and refrigerant working medium in every two adjacent substrate cavity bodies are not in circulation with each other; and
a plurality of heat dissipation fins, connected to the heat dissipation substrate.

2. The heat sink of claim 1, wherein the heat dissipation fins are two-phase heat dissipation fins.

3. The heat sink of claim 2, wherein a two-phase conduit in the two-phase heat dissipation fin is in communication with the substrate cavity body.

4. The heat sink of claim 3, wherein each of the substrate cavity bodies forms an independent loop with the corresponding two-phase conduit.

5. The heat sink of claim 4, wherein a number of two-phase conduits in the two-phase heat dissipation fin is the same as a number of the substrate cavities in communication with the two-phase heat dissipation fin.

6. The heat sink of claim 2, wherein a two-phase conduit in the two-phase heat dissipation fin is not in communication with the substrate cavity body.

7. The heat sink of claim 1, wherein a groove is provided on an inner cavity surface of the heat dissipation substrate to form a local liquid storage structure.

8. The heat sink of claim 1, wherein the inner cavity surface of the heat dissipation substrate is a rough surface.

9. The heat sink of claim 8, wherein the rough surface is prepared by sandblasting and/or by cold spraying of particles.

10. The heat sink of claim 1, wherein a plurality of supporting columns are arranged in the substrate cavity.

11. The heat sink of claim 10, wherein the number of the supporting columns is more than one, and at least two of the supporting columns have different diameters.

12. The heat sink of claim 1, wherein at least part of the heat dissipation fins are provided with a bent portion on a top thereof, and the bent portions of a plurality of neighboring heat dissipation fins form a cover structure.

13. The heat sink of claim 1, wherein the heat dissipation substrate is further provided with a peripheral flange configured for connecting to an external housing.

14. A communication device, comprising the heat sink of any one of claims 1 to 13.
